# EUROPÄISCHE PATENTANMELDUNG

(11) **EP 4 847 299 A1**
(43) Veröffentlichungstag der Anmeldung: **02.12.2026**
(21) Anmeldenummer: 26000041.9
(22) Anmeldetag: 22.05.2026
(51) Int. Cl.: B60L 53/18, B60L 53/10, B60L 53/16, B60L 53/30, G01R 22/00

(54) **EICHRELEVANTES KABELSYSTEM FÜR EINE LADESÄULE**

(30) Priorität: 27.05.2025 DE 102025120640
(71) Anmelder: HARTING Automotive GmbH, 32339 Espelkamp (DE)
(72) Erfinder: Beimdiek, Carsten, 32339 Espelkamp (DE); Itermann, Eugen, 32339 Espelkamp (DE); Grinblats, Marco, 32339 Espelkamp (DE)

(57) **Zusammenfassung**

Die Erfindung betrifft ein geeichtes System zum Aufladen eines Elektrofahrzeugs, aufweisend eine Ladestation (1) und zumindest ein Ladekabel (2),
wobei die Ladestation (1) eine Ladekabelanschlussdose (3) aufweist, wobei das Ladekabel (2) einen Netzsteckverbinder (4) zum Einstecken in die Ladekabelanschlussdose (3) der Ladestation (1) und einen Ladesteckverbinder (7) für ein Elektrofahrzeug aufweist, wobei das System beim Anschließen des Ladekabels (2) an die Ladestation (1) durch eine Aggregation von eichrelevanten Daten eichbar ist.

## Beschreibung

Die Erfindung geht aus von einem geeichten System zum Aufladen eines Elektrofahrzeugs nach der Gattung des unabhängigen Anspruchs 1. Die Erfindung bezieht sich weiterhin auf ein Ladekabel für ein solches System nach Anspruch 9. Die Erfindung bezieht sich ebenfalls auf ein Verfahren zur eichkonformen Inbetriebnahme eines Systems zum Aufladen eines Elektrofahrzeugs nach der Gattung des unabhängigen Anspruchs 14.

Ladestationen werden verwendet, um die Energiespeicher eines Elektrofahrzeugs mit Energie aufzufüllen bzw. nachzuladen. Die vorliegende Erfindung befasst sich mit so genannten Schnellladestationen. Hierbei handelt es sich um spezielle Ladeinfrastrukturen für Elektrofahrzeuge, die die Möglichkeit bieten, die Energiespeicher bzw. Batterien in kurzer Zeit aufzuladen. Hierbei treten Ladeströme von 800 Ampere oder mehr auf.

Bei Schnellladestationen ist eine so genannte Eichung eine rechtliche Voraussetzung, um diese betreiben zu können. Durch die Eichung von Schnellladestationen wird die Genauigkeit der abgegebenen Energiemenge gewährleistet.

### Stand der Technik

Die DE 10 2021 112 750 A1 betrifft ein Ladesystem, eine Ladestation und ein Ladekabel zur Übertragung elektrischer Energie an eine Traktionsbatterie eines Elektrofahrzeugs. Das Ladekabel umfasst einen Speicherbaustein, der zum Speichern kabelspezifischer Daten ausgebildet ist und mit mindestens einer Leitung kommunikativ verbunden ist, um eine Kommunikation mit der Ladestation zu ermöglichen.

Die DE 10 2022 124 490 A1 betrifft ein Steckverbindersystem mit einem Anbausteckverbinder und einem Gegensteckverbinder sowie einem integrierten RFID-System. Der Transpondermikrochip und die Transponderantenne sind jeweils in oder an dem Gegensteckverbinder angebracht. Die Readerantenne ist in Form einer umlaufenden Spule in oder an dem Anbausteckverbinder angebracht.

Die DE 10 2023 123 760 A1 zeigt eine Schnellladestation für Elektrofahrzeuge. Derartige Schnellladestationen bilden im Wesentlichen die öffentliche Ladeinfrastruktur für Elektrofahrzeuge und sind sehr wichtig für Personen, die an ihrem Wohnort (zu Hause) keine Lademöglichkeit für ihr Elektrofahrzeug haben. Je mehr betriebsbereite Schnellladesäulen für derartige Personen zur Verfügung stehen, desto schneller wird sich die Elektromobilität insgesamt etablieren.

Ein Ladekabel von Schnellladestationen weist einen hohen Kupferanteil auf. Insbesondere aufgrund der hohen Rohstoffpreise, werden diese Ladekabel daher zunehmend Opfer von Diebstählen. Die Kabel werden einfach mit schwerem Gerät, beispielweise einer Flex oder großen Schneidzangen, von der Schnellladestation abgeschnitten.

Ein derartiger Diebstahlschaden kann nicht schnell wieder behoben werden, denn zum Anschluss von Ladekabel im Hochstrombereich sind spezielle Fachkräfte notwendig. Außerdem verlieren derartige Schnellladestationen ihr Eichzertifikat.

Selbst wenn ein neues Ladekabel angeschlossen ist, muss erst eine Neueichung erfolgen, bevor die Ladestation wieder in Betrieb genommen werden darf. Hierdurch entsteht ein erheblicher wirtschaftlicher Schaden für den Betreiber einer solchen Ladestation. Zusätzlich wird ein kontinuierlicher Aufbau der Ladeinfrastruktur verlangsamt, was insgesamt das Vorantreiben der Elektromobilität verlangsamt.

Das Deutsche Patent- und Markenamt hat in der Prioritätsanmeldung zur vorliegenden Anmeldung den folgenden Stand der Technik recherchiert: DE 10 2021 112 750 A1, DE 10 2021 117 089 A1, DE 10 2022 208 547 A1, DE 10 2022 124 490 A2, DE 10 2023 123 760 A1 und DE 10 2018 115 371 A1.

### Aufgabenstellung

Die Aufgabe der Erfindung besteht darin, ein System zum Aufladen eines Elektrofahrzeugs vorzuschlagen, welches einen zuverlässigen und kostengünstigen Betrieb gewährleistet.

Die Aufgabe wird durch den Gegenstand des unabhängigen Anspruchs 1 gelöst.

Vorteilhafte Ausgestaltungen der Erfindung sind in den Unteransprüchen und der folgenden Beschreibung angegeben.

Bereits oben wurde erwähnt, dass Schnellladestationen einen Eichprozess durchlaufen müssen. Die Eichung ist der Prozess, durch den ein Messgerät (in diesem Fall die Ladestation) offiziell überprüft wird, um festzustellen, ob es innerhalb bestimmter gesetzlicher Normen und Toleranzen arbeitet. Bei der Schnellladestation soll sichergestellt werden, dass die gezahlte Energiemenge auch der tatsächlich geladenen Energiemenge entspricht.

Die Eichung von Schnellladesäulen für Elektroautos ist ein wichtiger Prozess, um sicherzustellen, dass die Verbraucher die korrekte Menge an Energie für die bezahlte Leistung erhalten. Hier sind die wesentlichen Schritte, wie eine Schnellladesäule geeicht wird.

In vielen Ländern, einschließlich Deutschland, sind Schnellladesäulen nach dem Mess- und Eichgesetz (MessEG) verpflichtet, geeicht zu sein. Dies stellt sicher, dass die Abrechnung für die Stromladung korrekt ist.

Die Eichung wird von zugelassenen Eichinstituten oder -behörden durchgeführt. Diese testen die Ladesäule unter spezifischen Bedingungen, um sicherzustellen, dass die Angaben zu Spannung, Stromstärke und Energiemenge korrekt sind.

Während des Eichprozesses wird die Ladesäule kalibriert. Dies bedeutet, dass die internen Messgeräte so eingestellt werden, dass sie genaue Werte liefern. Es werden Prüflasten verwendet, um die Leistung der Ladesäule zu überprüfen.

Nach Abschluss der Eichung erhält die Ladesäule ein Eichzertifikat, das die ordnungsgemäße Funktion und die Einhaltung der gesetzlichen Bestimmungen dokumentiert.

Das erfindungsgemäße, geeichte System ist zum Aufladen eines Elektrofahrzeugs vorgesehen. Mit Elektrofahrzeug sind im erfindungsgemäßen Sinne Fahrzeuge mit einem großen Speicher für elektrische Energie gemeint, insbesondere Elektroautos.

Das erfindungsgemäße System weist eine Ladestation und zumindest ein Ladekabel auf. Die Ladestation ist derart ausgestaltet, dass sie elektrische Energie bereitstellen kann und dementsprechend an eine elektrische Infrastruktur angeschlossen ist. Das Ladekabel ist mit der Ladestation derart gekoppelt, dass über das Ladekabel Energie an ein Elektrofahrzeug transportierbar ist.

Die erfindungsgemäße Ladestation weist eine Ladekabelanschlussdose auf. Das erfindungsgemäße Ladekabel weist einen dazu passenden Netzsteckverbinder auf. Über die Steckverbindung zwischen Ladekabelanschlussdose und Netzsteckverbinder wird das Ladekabel an die Ladestation angeschlossen.

Das erfindungsgemäße Ladekabel weist an seinem anderen Ende einen Ladesteckverbinder für ein Elektrofahrzeug auf. Der Ladesteckverbinder kann zum Aufladen in eine Ladebuchse eines Elektrofahrzeugs eingesteckt werden.

Das erfindungsgemäße Ladekabel weist ein Identifikationsmedium auf. Das Identifikationsmedium enthält entweder eichrelevante Kabeleichdaten oder verweist auf eichrelevante Kabeleichdaten. Im letzteren Fall kann das Identifikationsmedium beispielsweise auch einen Link enthalten, der zu den Kabeleichdaten führt, bspw. über eine Internetseite des Herstellers.

Als Identifikationsmedien können folgende Medien erfindungsgemäß eingesetzt werden:
- Barcode-Labels: Strichcodes, die von Barcode-Scannern gelesen werden können, um Daten zu speichern und abzurufen.
- QR-Codes: Eine spezielle Art von Barcode, die mit Smartphones und anderen Geräten gescannt werden kann, um Informationen zu verarbeiten.
- NFC-Tags (Near Field Communication): Ähnlich wie RFID, aber für die Kommunikation über sehr kurze Distanzen (wenige Zentimeter) geeignet. NFC wird oft in Mobilgeräten genutzt.
- Smartcards: Plastikkarten mit eingebauten Mikroprozessoren oder Speicherchips, die Daten speichern und in bestimmten Anwendungen, wie Zugangskontrollen oder Zahlungssystemen, verwendet werden.
- Magnetstreifen: Flexible Karten, die mit Daten ausgestattet sind und durch Magnetfelder gelesen werden können, wie z.B. bei Kreditkarten und Zugangsberechtigungen.
- USB-Sticks: Tragbare Speichergeräte, die Daten speichert und über USB-Anschlüsse ausgelesen werden kann, oft verwendet für digitale Datenübertragungen.
- Serverbasierte Datenspeicherung: Datenbanken oder Cloud-Speicher, in denen eichrelevante Daten zentral gespeichert und über Netzwerke abgerufen werden können.
- Ein einfacher Zettel, ein Schildchen oder Ähnlichen kann auch als Identifikationsmedium fungieren.

In einer Ausführungsform der Erfindung weist die Ladestation ein Lesegerät auf, über welches die Kabeleichdaten auslesen bzw. einlesbar sind. Das Lesegerät kann so ausgeführt sein, dass die Eichdaten automatisch, beim Einstecken des Ladekabels an die Ladestation, ausgelesen werden.

Als Lesegerät können im erfindungsgemäßen Sinne folgende Komponenten zum Einsatz kommen:
- RFID-Reader: Ein Gerät, das speziell zum Auslesen von Informationen von RFID-Tags ausgelegt ist. RFID-Reader senden ein Signal, das von den Tags empfangen wird, um die gespeicherten Daten zu übermitteln.
- Barcode-Scanner: Ein Gerät, das Barcodes scannt und die darin enthaltenen Informationen ausliest. Diese Geräte sind in vielen Einzelhandels- und Lagerumgebungen weit verbreitet.
- NFC-Reader: Ein nahfeldkommunikationsfähiges Gerät, das Daten von NFC-fähigen Tags oder Geräten ausliest. NFC-Reader sind oft in Smartphones integriert und werden häufig für Zugangskontrollen oder mobile Zahlungsmethoden verwendet.
- Smartcard-Reader: Ein Gerät, das Informationen von Smartcards ausliest, die in unterschiedlichen Anwendungen wie Zugangskontrollen, Bezahlmethoden oder Personalausweisen verwendet werden.
- Datenschnittstelle: Im erfindungsgemäßen Sinne kann auch eine Datenschnittstelle (z.B. eine API oder ein spezieller Anschluss) als Lesegerät betrachtet werden, wenn sie Informationen von bestimmten Identifikationsmedien überträgt oder verarbeitet.

Alternativ oder zusätzlich kann die Ladestation ein Eingabegerät aufweisen, über welche die Kabeleichdaten eingebbar. Das Eingabegerät kann auch als Backup dienen, falls die automatische Erkennung, die oben beschrieben wird, nicht funktioniert oder das Identifikationsmedium oder das Lesegerät beschädigt sind. In diesem Fall kann beispielsweise eine Tastatur und Monitor die Funktion des Eingabegerätes übernehmen.

In einer Ausführungsform der Erfindung weist die Ladestation einen Speicherbaustein auf. Auf dem Speicherbaustein sind Ladestationeichdaten gespeichert.

Als erfindungsgemäßer Speicherbaustein kommen folgende Komponenten in Betracht:
- Flash-Speicher: Beispielsweise USB-Sticks.
- SD-Karten: Verwenden häufige Anwendungen in Geräten zur

Datenspeicherung, könnte in die Ladestationen integriert werden.
- SSD (Solid State Drives): Schnelle und robuste Speicheroptionen, die für die Speicherung großer Datenmengen verwendet werden können.
- HDD (Hard Disk Drives): Traditionelle Festplatten, die ebenfalls in größeren Systemen zur Datenspeicherung eingesetzt werden können.
- Cloud-Speicher: Speicherung und Abruf von Daten über das Internet, was eine zentrale Datenzugänglichkeit und -sicherung ermöglicht.

In einer Ausführungsform der Erfindung weist die Ladestation eine Recheneinheit auf. Die Recheneinheit ist dazu ausgestaltet die Kabeleichdaten und die Ladestationeichdaten durch Datenaggregation zur Eichung des Systems zu kombinieren. Das bedeutet, dass die jeweiligen Eichdaten der Ladestation und des Ladekabels derart miteinander verknüpft werden, dass hinterher das gesamte System (Ladestation + Ladekabel) geeicht sind bzw. als geeicht gelten.

Das schließt natürlich nicht aus, dass die Ladestation und das Ladekabel jeweils für sich genommen ebenfalls rechtlich gesehen als geeicht gelten. Erfindungsgemäß würden in diesem Fall dann zwei geeichte Komponenten zusammengesetzt und als Gesamtsystem verwendet. Das Gesamtsystem ist durch eine Kombination der jeweiligen Eichdaten ebenfalls geeicht.

Die Erfindung hat diverse Vorteile:
- Bei einem Diebstahl des Ladekabels, könnte dieses schnell durch ein neues Kabel ersetzt werden. Das System müsste hinterher nicht komplett neu geeicht und freigegeben werden.
- Weiterhin könnte das Ladekabel von einer Nicht-Fachkraft ausgetauscht werden. Zum Einstecken bzw. Anschließen des Ladekabels an die Ladestation ist kein Hochspannungstechniker oder eine Fachkraft mit einer ähnlich hohen Qualifikation erforderlich. Es genügt lediglich das Anschließen eines (neuen) Ladekabels, was vom System selbständig erkennbar ist und das System eine Inbetriebnahme oder eine Neuinbestriebnahme durchführt.
- Ladekabel könnten präventiv, beispielsweise bereits vor dem Erreichen einer Verschleißgrenze ausgetauscht werden.
- Ladekabel können vor Ort gelagert und zum Austausch bereitgestellt werden, bspw. an Tankstellen, die Ladestationen aufweisen.
- Die Ladekabellänge könnte an den jeweiligen Einsatzort angepasst werden. Die Ladestationen könnte am Fließband hergestellt und erst später eine vom Betreiber gewünschte bzw. benötigte Kabellänge installiert werden.

In einer Ausführungsform der Erfindung ist die Ladestation eine Schnellladestation. Hierbei wird die Ladeenergie mit einer Gleichspannung übertragen. Mit derartigen Ladestationen können Elektroautos in sehr kurzer Zeit aufgeladen werden. Die daran angeschlossenen Ladekabel haben einen hohen Leiterquerschnitt. Die Leiterquerschnitte können bis zu 100 mm² pro Leiter sein. In einem Kabel sind bis zu 4 stromführenden Leitern enthalten. Die Kabel sind dadurch sehr dick bzw. massiv ausgeführt.

Das erfindungsgemäße Ladekabel weist an einem Ende einen Netzsteckverbinder auf. Über den Netzsteckverbinder kann das Ladekabel an die Ladestation angeschlossen werden. An seinem anderen Ende weist das Ladekabel einen Ladesteckverbinder für ein Elektrofahrzeug auf. Hierbei handelt es sich vorzugsweise um einen Schnellladesteckverbinder, der in Fachkreisen auch CCS-Ladesteckverbinder genannt wird.

In einer Ausführungsform der Erfindung weist das Ladekabel ein Identifikationsmedium auf. Auf dem Identifikationsmedium sind eichrelevante Kabeleichdaten gespeichert. Im Wesentlichen geht es um die Gesamtlänge des Kabels und den Übergangswiderständen der Kabelschnittstellen. Die Kabeleichdaten werden, wie bereits oben erwähnt, genutzt, um ein insgesamt geeichtes System einer Ladestation und eines Ladekabels bereitzustellen.

Kabeleichdaten können das Längenmaß und/oder den Kabelquerschnitt und/oder das Material der Leiter und/oder den ohmschen Widerstand der Leiter und/oder den Temperaturkoeffizienten und/oder die Leistungsfähigkeit und/oder die die Übergangswiderstände an den Steckerbuchsen und/oder das Isolationslevel beinhalten oder repräsentieren oder als eine Wertangabe abbilden.

Insgesamt dienen die Eichdaten zur Messgenauigkeit der übertragenen Ladeenergie und Einhaltung der gesetzlichen Eichvorschriften.

Im Folgenden werden die möglichen Daten nochmals kurz näher erläutert:
- Längenmaß: Die Länge des Ladekabels ist entscheidend, da sie den ohmschen Widerstand beeinflusst. Kabel mit unterschiedlichen Längen haben unterschiedliche Verlustleistungen:
- Querschnitt: Der Querschnitt der Adern im Ladekabel (z.B. 15 mm², 25 mm²) beeinflusst den Widerstand, die Strombelastbarkeit und somit den Energieverlust während des Ladevorgangs.
- Material: Das Material des Kabels (z.B. Kupfer, Aluminium) hat Auswirkungen auf den elektrischen Widerstand. Kupfer hat in der Regel einen niedrigeren Widerstand und bessere Leitfähigkeit als Aluminium.
- Ohmscher Widerstand: Der spezifische Widerstand des verwendeten Materials und der Gesamtübergangs- und Kontaktwiderstände an den Schnittstellen (z.B. am Ladestecker) müssen bekannt sein.
- Temperaturkoeffizient: Der Temperaturkoeffizient des Kabelmaterials kann auch eine Rolle spielen, da sich der Widerstand bei Temperaturänderungen verändert.
- Leistungsfähigkeit: Die maximale Stromstärke, die das Ladekabel führen kann, ist ebenfalls relevant, insbesondere wenn die Eichung unter Lastbedingungen erfolgt.
- Übergangswiderstände: Die Übergangswiderstände an den Steckerbuchsen (z.B. zwischen Ladestecker und Fahrzeug) müssen ebenfalls berücksichtigt werden. Diese können signifikant zu den Gesamtverlusten beitragen und wirken sich auf die tatsächlich gelieferte Energie aus.
- Kabeltyp: Der Typ des verwendeten Kabels (z.B. H07BN4-F, Type 2) und dessen Spezifikation müssen dokumentiert sein, um sicherzustellen, dass sie den geltenden Normen entsprechen.
- Isolationslevel und Umgebungsbedingungen: Informationen über die Isolierung des Kabels und darüber, wie es bei verschiedenen Umgebungsbedingungen (z.B. Temperatur, Feuchtigkeit) abschneidet, sind auch von Bedeutung.

In einer Ausführungsform der Erfindung ist der Netzsteckverbinder ein modularer Industriesteckverbinder. Der modulare Industriesteckverbinder weist zumindest zwei oder mehr Steckverbindermodule auf. Ein solcher modularer Industriesteckverbinder ist beispielsweise in der DE 10 2018 115 371 A1 gezeigt.

Durch die Verwendung von bekannten Schnittstellen, kann das erfindungsgemäße Ladekabel bzw. das erfindungsgemäße System kostengünstig gestaltet werden.

In einer Ausführungsform der Erfindung weist der modulare Industriesteckverbinder ein Powermodul zur Übertragung hoher Stromstärken und/oder ein PE-Modul zur Erdung und/oder Signalübertragungsmodul und/oder ein Identifikationsmodul aufweist. Dadurch kann der modulare Industriesteckverbinder sämtliche Ansprüche des Systems bzgl. Strom- und Datenübertragung erfüllen.

Das eichkonforme System aus Ladestation und Ladekabel kann wie folgt in Betrieb genommen werden:
- Das Ladekabel wird zunächst an die Ladestation angeschlossen.
- Dabei werden die Kabeleichdaten an die Ladestation übergeben. Entweder erfolgt dies automatisiert über ein Identifikationsmedium und ein passendes Lesegerät oder die Kabeleichdaten werden manuell eingegeben.
- Anschließend werden die Kabeleichdaten und die Ladestationeichdaten durch Datenaggregation zur Eichung des Systems kombiniert.
- Danach ist das System betriebsbereit.

### Ausführungsbeispiel

Ein Ausführungsbeispiel der Erfindung ist in den Zeichnungen dargestellt und wird im Folgenden näher erläutert. Es zeigen:
- Fig. 1: eine schematische Darstellung eines erfindungsgemäßen Systems aus Ladestation und Ladekabel,
- Fig. 2: eine perspektivische Darstellung einer Ladekabelanschlussdose der Ladestation und
- Fig. 3: eine perspektivische Darstellung eines Netzsteckverbinders des Ladekabels.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein. Richtungsangaben wie beispielsweise "links", "rechts", "oben" und "unten" sind mit Bezug auf die jeweilige Figur zu verstehen und können in den einzelnen Darstellungen gegenüber dem dargestellten Objekt variieren.

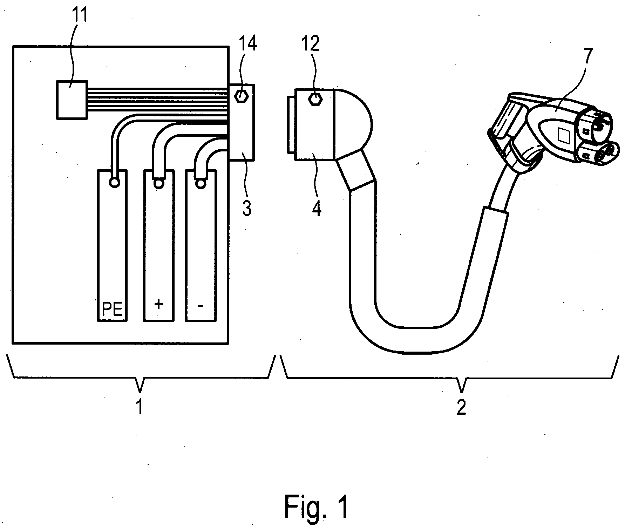

Die Figur 1 zeigt ein geeichtes System zum Aufladen eines Elektrofahrzeugs. Beim Elektrofahrzeug handelt es sich hauptsächlich um Elektroautos oder größere Fahrzeuge, beispielsweise Elektro-LKW. Es sind im Wesentlichen Fahrzeuge gemeint, die eine große Energiemenge in kurzer Zeit aufnehmen können, also schnellladefähige Elektrofahrzeuge.

Das System weist eine Ladestation 1 und ein Ladekabel 2 auf. Die Ladestation weist eine Ladekabelanschlussdose 3 auf. Das Ladekabel 2 weist an einem Ende einen dazu passenden Netzsteckverbinder 4 auf. Durch das Einstecken des Netzsteckverbinders 4 in die Ladekabelanschlussdose 3, ist das Ladekabel 2 an der Ladestation 1 angeschlossen.

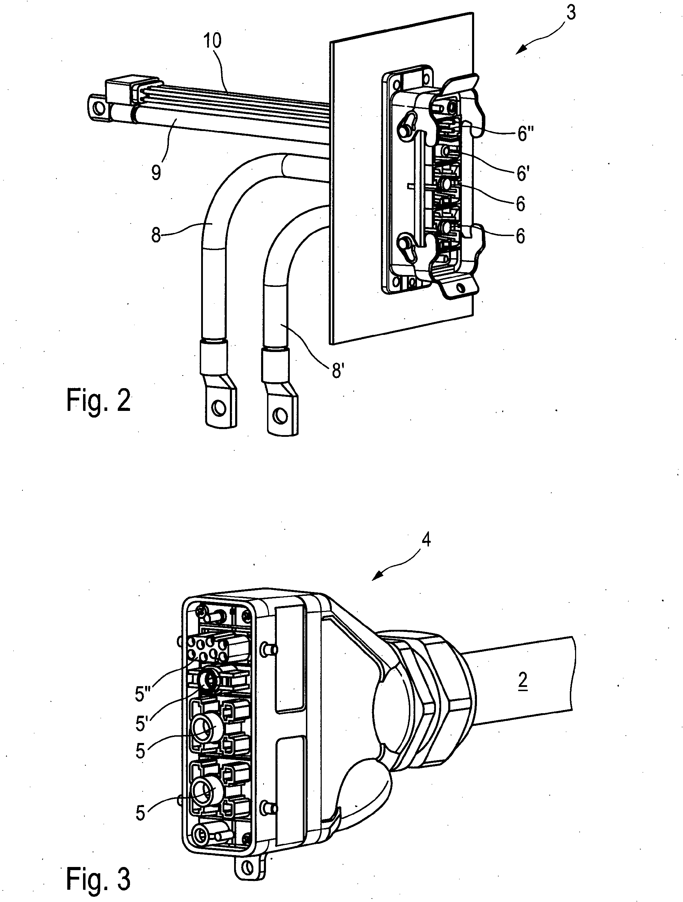

Eine Ausführungsvariante des Netzsteckverbinders 4 ist in Figur 3 dargestellt. Hier ist der Netzsteckverbinder 4 als modularer Industriesteckverbinder ausgeführt. Der modulare Industriesteckverbinder ist mit unterschiedlichen Steckverbindermodulen 5, 5', 5" ausgestattet.

Die Steckverbindermodule 5, 5', 5" werden in einem Halterahmen im Steckverbindergehäuse gehalten.

Zumindest ein Powermodul 5 ist zur Übertragung hoher Stromstärken vorgesehen. Zumindest ein PE-Modul 5' zur Erdung der Steckverbindung ist vorgesehen. Ein weiteres Steckverbindermodul 5" ist als Signalübertragungsmodul ausgeführt und insbesondere zur Kommunikation von Ladestation mit dem Elektrofahrzeug vorgesehen.

Die Ladekabelanschlussdose 3 ist in Figur 2 perspektivisch dargestellt. Die Ladekabelanschlussdose 3 besteht im Wesentlichen aus einem Anbaugehäuse, welches zum Netzsteckverbinder 4 passende Gegensteckverbindermodule 6, 6', 6" aufweist.

Von der Ladekabelanschlussdose 3 führen stromführende Leitungen 8, 8' (Plus und Minus) ins Innere der Ladestation 1. Der entsprechende Netzanschluss ist hier nicht gezeigt. Weiterhin ist ein PE-Leiter 9 zur Erdung des Systems und mehrere Signalleiter 10 insbesondere zur Kommunikation mit dem Elektrofahrzeug zu erkennen. Die genaue Funktionsweise des Ladevorgangs wird im Folgenden nicht näher erläutert.

An seinem anderen - dem Netzsteckverbinders 4 gegenüberliegendem - Ende weist das Ladekabel 2 einen Ladesteckverbinder 7 für ein Elektrofahrzeug auf. Der Ladesteckverbinder 7 ist als Schnellladesteckverbinder (CCS-Ladesteckverbinder) ausgeführt.

Die Ladestation 1 weist eine Recheneinheit mit Speicherbaustein 11 auf. Auf dem Speicherbaustein sind Ladestationeichdaten gespeichert. Die Ladestation 1, ohne angeschlossenes Kabel, kann nach den gesetzlichen Vorgaben bereits als geeicht gelten.

Das Ladekabel 2 weist ein Identifikationsmedium 12 auf. Auf dem Identifikationsmedium 12 sind eichrelevante Kabeleichdaten gespeichert bzw. enthalten. Das Ladekabel 2 kann, ohne Anschluss an die Ladestation 1, nach gesetzlichen Vorgaben bereits als geeicht gelten.

Die Ladestation 1 weist ein zum Identifikationsmedium 12 des Ladekabels 2 passendes Lesegerät 14 auf. In dem hier gezeigten Ausführungsbeispiel sind Identifikationsmedium 12 und Lesegerät an der Steckschnittstelle zwischen Ladestation 1 und Ladekabel 2 positioniert. Hier könnte beispielsweise die Ladekabelanschlussdose 3 das Lesegerät 14 aufweisen und der Netzsteckverbinder 4 könnte das Identifikationsmedium aufweisen. Beim Anschluss des Ladekabels 2 an die Ladestation 1 werden die Kabeleichdaten des Kabels 2 an die Ladestation 1 übergeben bzw. übertragen. Durch die Recheneinheit 11 werden die Kabeleichdaten und die Ladestationeichdaten mithilfe einer Datenaggregation zur Eichung des Systems kombiniert. Das System (Ladestation 1 und Ladekabel 2) gilt nach gesetzlichen Vorgaben als geeicht.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1: Ladestation
- 2: Ladekabel
- 3: Ladekabelanschlussdose
- 4: Netzsteckverbinder
- 5: Steckverbindermodul
- 6: Gegensteckverbindermodul
- 7: Ladesteckverbinder
- 8: Stromführende Leitung
- 9: PE-Leiter
- 10: Signalleiter
- 11: Recheneinheit
- 12: Identifikationsmedium

- 14: Lesegerät

## Patentansprüche

1. Geeichtes System zum Aufladen eines Elektrofahrzeugs, aufweisend eine Ladestation (1) und zumindest ein Ladekabel (2), wobei die Ladestation (1) eine Ladekabelanschlussdose (3) aufweist,
wobei das Ladekabel (2) einen Netzsteckverbinder (4) zum Einstecken in die Ladekabelanschlussdose (3) der Ladestation (1) und einen Ladesteckverbinder (7) für ein Elektrofahrzeug aufweist, wobei die Ladestation (1) einen Speicherbaustein (11) aufweist, auf welchem Ladestationeichdaten gespeichert sind,
wobei die Ladestation (1) eine Recheneinheit (11) aufweist, welche beim Anschließen des Ladekabels (2) an die Ladestation (1) Kabeleichdaten und die Ladestationeichdaten durch Datenaggregation zur Eichung des Systems kombiniert, sodass das System als geeicht gilt.

2. Geeichtes System nach Anspruch 1
**dadurch gekennzeichnet, dass**
das Ladekabel (2) ein Identifikationsmedium (12) aufweist, welches eichrelevante Kabeleichdaten enthält oder welches auf eichrelevante Kabeleichdaten verweist.

3. Geeichtes System nach Anspruch 1 oder 2
**dadurch gekennzeichnet, dass**
die Ladestation (1) ein Lesegerät (14) aufweist, welches die Kabeleichdaten auslesen kann und/oder
dass die Ladestation (1) ein Eingabegerät aufweist, über welche die Kabeleichdaten eingebbar sind.

4. Geeichtes System nach einem der Ansprüche 1 bis 3 **dadurch gekennzeichnet, dass**
die Ladestation (1) eine Schnellladestation ist, die die Ladeenergie mit einer Gleichspannung überträgt.

5. Geeichtes System nach einem der Ansprüche 1 bis 4
**dadurch gekennzeichnet, dass**
die Ladekabelanschlussdose (3) das Lesegerät (14) aufweist.

6. Geeichtes System nach Anspruch 2 **dadurch gekennzeichnet, dass** der Netzsteckverbinder (4) das Identifikationsmedium (12) aufweist.

7. Geeichtes System nach einem der Ansprüche 1 bis 6 **dadurch gekennzeichnet, dass**
das Identifikationsmedium (12) ein RFID-Tag, ein NFC-Tag, ein QR-Code oder ein Barcode ist.

8. Geeichtes System nach einem der Ansprüche 1 bis 7 **dadurch gekennzeichnet, dass**
das Lesegerät (14) ein RFID-Reader, ein NFC-Reader oder ein Barcode-Scanner ist.

9. Ladekabel für ein geeichtes System nach einem der Ansprüche 1 bis 8 **dadurch gekennzeichnet, dass**
das Ladekabel (2) an einem Ende einen Netzsteckverbinder (4) zum Anschluss an die Ladestation (1) aufweist und dass das Ladekabel (2) am anderen Ende einen Ladesteckverbinder (7) für ein Elektrofahrzeug aufweist und dass das Ladekabel (2) ein Identifikationsmedium (12) aufweist, welches eichrelevante Kabeleichdaten enthält.

10. Ladekabel (2) nach Anspruch 9 **dadurch gekennzeichnet, dass** die Kabeleichdaten das Längenmaß und/oder den Kabelquerschnitt und/oder das Material der Leiter und/oder den ohmschen Widerstand der Leiter und/oder den Temperaturkoeffizienten und/oder die Leistungsfähigkeit und/oder die Übergangswiderstände an den Steckerbuchsen und/oder das Isolationslevel beinhalten.

11. Ladekabel (2) nach Anspruch 9 oder 10 **dadurch gekennzeichnet, dass** der Netzsteckverbinder (4) ein modularer Industriesteckverbinder ist, der zumindest zwei oder mehr Steckverbindermodule (5, 5', 5") aufweist.

12. Ladekabel (2) nach Anspruch 11
**dadurch gekennzeichnet, dass** der modulare Industriesteckverbinder ein Powermodul (5) zur Übertragung hoher Stromstärken und/oder ein PE-Modul (5') zur Erdung und/oder Signalübertragungsmodul (5") und/oder ein Identifikationsmodul aufweist.

13. Ladekabel (2) nach Anspruch 12
**dadurch gekennzeichnet, dass** das Identifikationsmodul das Identifikationsmedium (12) ist.

14. Ladekabel (2) nach einem der Ansprüche 9 bis 13 **dadurch gekennzeichnet, dass** der Ladesteckverbinder (7) ein CCS-Ladesteckverbinder ist.

15. Verfahren zur eichkonformen Inbetriebnahme eines Systems zum Aufladen eines Elektrofahrzeugs, welches eine Ladestation (1) und zumindest ein Ladekabel (2) aufweist,
wobei das Ladekabel (2) Kabeleichdaten aufweist und wobei die Ladestation (1) Ladestationeichdaten auf einem Speicherbaustein (11) aufweist,
wobei das Ladekabel (2) an die Ladestation (1) angeschlossen wird und dabei die Kabeleichdaten an die Ladestation (1) übergeben werden und
wobei eine Recheneinheit (11) der Ladestation (1) die Kabeleichdaten und die Ladestationeichdaten durch Datenaggregation zur Eichung des Systems kombiniert, sodass das System als geeicht gilt.
